(19) Europäisches Patentamt
European Patent Office
Office européen des brevets

(11) EP 1 513 020 A2

(12) EUROPEAN PATENT APPLICATION

(43) Date of publication:
09.03.2005 Bulletin 2005/10

(51) Int Cl.[7]: G03F 7/20, G03F 7/32

(21) Application number: 04021040.3

(22) Date of filing: 03.09.2004

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(30) Priority: 04.09.2003 JP 2003312623

(71) Applicant: Fuji Photo Film Co., Ltd.
Kanagawa (JP)

(72) Inventor: Kondo, Shunichi
Haibara-gun Shizuoka (JP)

(74) Representative: HOFFMANN - EITLE
Patent- und Rechtsanwälte
Arabellastrasse 4
81925 München (DE)

# (54) Photosensitive lithographic printing plate

(57) A photosensitive lithographic printing plate comprising a support and a photopolymerizable photosensitive layer containing an addition-polymerizable compound having at least one ethylenically unsaturated double bond, an alkali developer-soluble or swellable binder and a photopolymerization initiator, wherein a ratio of a sensitivity upon exposure at 30°C to a sensitivity upon exposure at 10°C is from 1.0 to 1.7.

EP 1 513 020 A2

## Description

### FIELD OF THE INVENTION

The present invention relates to a photosensitive lithographic printing plate utilizing photopolymerization, more specifically, the present invention relates to a photosensitive lithographic printing plate for CTP (computer-to-plate) system, which is less dependent on the temperature at exposure and less affected by the temperature of the exposing machine (plate setter).

### BACKGROUND OF THE INVENTION

The image formation of a negative photosensitive lithographic printing plate is generally performed through a process of coating a photosensitive composition on a support such as surface-roughened aluminum plate, exposing a desired image to cause polymerization or crosslinking in the image area (portion irradiated with light) and thereby insolubilize the area in a developer, and dissolving out the non-image area with a developer. As for the photosensitive composition used for this purpose, a photopolymerizable compound has been heretofore well known and some of these compounds are used in practice. Also, a recently proposed high-sensitive photopolymer adopting the technique of photopolymerization system highly sensitive to visible light is succeeded in elevating the sensitivity even to a region of enabling use in direct plate-making by a visible laser and this photopolymer is wide-spreading as a CTP plate.

Usually, several tens to several hundreds of CTP plates in the superposed state are housed in a plate setter and after removing interleaves, transported to an exposure drum and exposed on the exposure drum based on electronic data from a computer. The apparatus therefor is classified by the exposure drum system into an internal type, an external type, a flat bed type and the like, but in many cases, the exposure drum temperature is set to 10 to 30°C as a recommended environment for reducing the effect of the exposure drum temperature.

The photopolymerization system is a reaction system mainly undergoing a monomer chain polymerization reaction (collision reaction) under the action of an initiator radical and having a large temperature dependency. Therefore, even within the recommended temperature (10 to 30°C), the sensitivity differs depending on the exposure temperature in the plate setter and this gives rise to a problem on the lithographic printing plate that the dot area is readily changed. Particularly, in the winter season, a fairly long time is necessary for the exposure drum to reach the recommended temperature after turning on an air conditioner and a plate setter and therefore, the exposure is sometimes performed at a temperature lower than the recommended temperature. If the case is so, there arises a problem such as extreme deterioration of small dot precision. Accordingly, development of a plate material having small temperature dependency is being demanded.

The CTP plate using a photopolymerization system is commonly called a high-sensitive photopolymer and regarding its basic technique, many patent applications have been filed. Examples thereof include a photopolymerization system comprising a cyclic triazine initiator and a merocyanine initiation system (JP-A-54-151024 (the term "JP-A" as used herein means an "unexamined published Japanese patent application")), a photopolymerization system comprising a dye and an active halogen compound initiation system (JP-A-63-258903), a photopolymerization system comprising a dye and a borate compound initiation system (JP-A-1-298348), and photopolymerization systems comprising various dyes and a titanocene initiation system (JP-A-63-21110, JP-A-6-295061, JP-A-8-334897 and JP-A-2000-147763).

In these patent publications, the effect of temperature at exposure of the photopolymerization system on the sensitivity is not referred to at all and a guideline for improvement cannot be obtained. In fact, when the sensitivity of plate materials using these photopolymerization systems is examined by changing the temperature at exposure, the sensitivity is higher as the temperature is higher and in most plate materials, the sensitivity at 30°C falls in the range from about 2 to 4 times the sensitivity at 10°C. As is clear from this, improvement is necessary for stabilizing the dot area and the like of the plate material produced.

In improving the temperature dependency, publications and the like describing the improvement range of causing no problem such as fluctuation of dot area at printing in an actual photopolymerization-system plate material are not known and the goal of improvement of the temperature dependency is unclear. Clarification of this point is also demanded.

### SUMMARY OF THE INVENTION

An object of the present invention is to provide a photosensitive lithographic printing plate (plate material) which can ensure plate making of causing less change in the dot area percentage even when the temperature at exposure is changed and which can realize, in an actual printed matter, reproduction of a constant dot area and stable reproduction of fine line, fine letter, outline fine line and outline fine letter.

As a result of intensive investigations to solve those problems, the present inventors have found that when the temperature dependency of photosensitive lithographic printing plate at the exposure wavelength is adjusted to an appropriate range, actual printed matters can have constant quality in the halftone dot quality and fine line reproducibility. The present invention has been accomplished based on this finding.
That is, the present invention provides a photosensitive lithographic printing plate comprising a photopolymerizable photosensitive layer containing an addition-polymerizable compound having at least one ethylenically unsaturated double bond, an alkali developer-soluble or swellable binder and a photopolymerization initiator, wherein the ratio ($S_{30}/S_{10}$) of the sensitivity ($S_{30}$) upon exposure at 30°C to the sensitivity ($S_{10}$) upon exposure at 10°C is from 1.0 to 1.7.

## DETAILED DESCRIPTION OF THE INVENTION

The present invention is described in detail below.
The present inventors have found that when the ratio of sensitivity upon exposure at 30°C to sensitivity upon exposure at 10°C is from 1.0 to 1.7 at the exposure wavelength used, the halftone dot quality and fine line reproducibility of printed matters can be maintained constant.
The photosensitive lithographic printing plate of the present invention usually has a constitution that a photopolymerizable photosensitive layer and if desired, an interlayer and a protective layer are provided on a support such as aluminum plate. The photopolymerizable photosensitive layer contains an addition-polymerizable compound having at least one ethylenically unsaturated double bond, an alkali developer-soluble or swellable binder, and a photopolymerization initiator.
The present inventors have found that for adjusting the ratio of sensitivity upon exposure at 30°C to sensitivity upon exposure at 10°C to fall in the range from 1.0 to 1.7, the activation energy of photopolymerization reaction in the photopolymerizable photosensitive layer is preferably lowered to decrease the temperature dependency, particularly, softening of the polymerizable photosensitive layer is effective.

[Photopolymerizable Photosensitive Layer]

The photopolymerizable photosensitive layer is described below.
The ratio of sensitivity upon exposure at 30°C to sensitivity upon exposure at 10°C is from 1.0 to 1.7, preferably from 1.0 to 1.5, more preferably from 1.0 to 1.3.
For this purpose, the softening point of the photopolymerizable photosensitive layer is preferably 45°C or less, more preferably 40°C or less, and further more preferably 35°C or less.
The "softening point" as used herein means a temperature when a substance deforms under heating and starts softening, and this is defined in JIS-K2406 as a temperature when a steel ball put in a sample falls a fixed distance. The softening point can be measured, for example, by using an apparatus described in Encyclopaedia Chimica 6, Kyoritsu Shuppan (February, 1971), which is used for measuring the softening point of asphalt, tar pitch and the like and which is in accordance with JIS-K2406.
In order to obtain a photopolymerizable photosensitive layer having a softening point of 45°C or less, this can be achieved, for example, by using a binder having a low glass transition point (Tg), increasing the amount of a liquid compound (monomer) containing an ethylenically unsaturated double bond, or adding a plasticizer and a softening agent to the polymerizable photosensitive layer.
To increase the amount of the monomer is preferred, because the aging stability and the film property after photopolymerization are less affected. For obtaining a softening point of 45°C or less, the monomer is preferably added in an amount of 1.5 times by weight (mass) or more of the binder polymer.
In the case where the monomer has low hydrophilicity, the developability with an alkali developer generally decreases and therefore, missing of dot or missing of fine line or the like in the solid part occurs seriously in some cases. For solving this problem, it is effective to use an alkali developer having a pH of 10.5 to 13.5 and containing a compound having a polyoxyethylene group.
Respective components contained in the photopolymerizable photosensitive layer are described below.
The photopolymerizable photosensitive composition for forming the photopolymerizable photosensitive layer comprises, as essential components, (a) an addition-polymerizable compound having at least one ethylenically unsaturated double bond, (b) an alkali developer-soluble o swellable binder (binding agent) and (c) a photopolymerization initiator (system) and, if desired, may additionally contain various compounds such as coloring agent, plasticizer and thermal polymerization inhibitor.

(a) Addition-polymerizable compound having at least one ethylenically unsaturated double bond (hereinafter, sometimes also referred to as an "ethylenically unsaturated bond-containing compound")

The ethylenically unsaturated bond-containing compound is a compound having an ethylenically unsaturated

bond which is crosslinked and cured by bringing about addition polymerization under the action of a photopolymerization initiator when the photopolymerizable composition is irradiated with actinic rays. The addition-polymerizable compound containing an ethylenically unsaturated bond can be arbitrarily selected from compounds having at least one, preferably two or more, terminal ethylenically unsaturated bond(s). These compounds have a chemical form such as monomer, prepolymer (that is, dimer, trimer or oligomer) or a mixture or copolymer thereof.

Examples of the monomer and its copolymer include esters of an unsaturated carboxylic acid (e.g., acrylic acid, methacrylic acid, itaconic acid, crotonic acid, isocrotonic acid, maleic acid) with an aliphatic polyhydric alcohol compound, and amides of an unsaturated carboxylic acid with an aliphatic polyvalent amine compound.

As for specific examples of the ester monomer of an aliphatic polyhydric alcohol compound with an unsaturated carboxylic acid, examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri (acryloyloxyethyl) isocyanurate and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl] dimethylmethane.

Examples of the itaconic acid ester include ethylene glycol diitaconate, propylene glycol diitaconate, 1,5-butanediol diitaconate, 1,4-butanediol diitaconate, tetramethylene glycol diitaconate, pentaerythritol diitaconate and sorbitol tetraitaconate.

Examples of the crotonic acid ester include ethylene glycol dicrotonate, tetramethylene glycol dicrotonate, pentaerythritol dicrotonate and sorbitol tetradicrotonate.

Examples of the isocrotonic acid ester include ethylene glycol diisocrotonate, pentaerythritol diisocrotonate and sorbitol tetraisocrotonate.

Examples of the maleic acid ester include ethylene glycol dimaleate, triethylene glycol dimaleate, pentaerythritol dimaleate and sorbitol tetramaleate. Also, a mixture of these ester monomers may also be used.

Specific examples of the amide monomer of an aliphatic polyhydric amine compound with an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Other examples include vinyl urethane compounds having two or more polymerizable vinyl groups within one molecule described in JP-B-48-41708 (the term "JP-B" as used herein means an "examined Japanese patent publication"), which is produced by adding a hydroxyl group-containing vinyl monomer represented by the following formula (A) to a polyisocyanate compound having two or more isocyanate groups within one molecule:

$$CH_2=C(R^1)COOCH_2CH(R^2)OH \quad (A)$$

(wherein $R^1$ and $R^2$ each represents H or $CH_3$).

Still other examples include polyfunctional acrylates or methacrylates such as urethane acrylates described in JP-A-51-37193 and JP-B-2-32293, polyester acrylates described in JP-A-48-64183, JP-B-49-43191 and JP-B-52-30490, and epoxy acrylates obtained by an epoxy resin and a (meth)acrylic acid. In addition, those described as a photocurable monomer or oligomer in Nippon Secchaku Kyokai Shi (Journal of the Adhesion Society of Japan), Vol. 20, No. 7, pp. 300-308 (1984) can also be used.

The amount of the ethylenically unsaturated bond-containing compound used is generally from 5 to 80 weight%, preferably from 30 to 70 weight%, in the photopolymerizable photosensitive layer.

(b) Alkali developer-soluble or swellable binder

The binder for use in the photopolymerizable photosensitive layer is required not only to function as a film-forming agent for the photopolymerizable composition used in the photopolymerizable layer but also to dissolve in an alkali developer and therefore, an organic high-molecular polymer which is soluble or swellable in an alkali developer is used. When this organic high-molecular polymer used is, for example, a water-soluble organic high-molecular polymer, water development can be performed. Examples of such an organic high-molecular polymer include addition polymers having a carboxylic acid group on the side chain described, for example, in JP-A-59-44615, JP-B-54-34327, JP-B-58-12577, JP-B-54-25957, JP-A-54-92723, JP-A-59-53836 and JP-A-59-71048, such as methacrylic acid copolymer, acrylic acid copolymer, itaconic acid copolymer, crotonic acid copolymer, maleic acid copolymer and partially esterified maleic acid copolymer.

Also, acidic cellulose derivatives having a carboxylic acid group on the side chain may be used. Other than these compounds, those obtained by adding a cyclic acid anhydride to an addition polymer having a hydroxyl group are useful. Among these, preferred are [benzyl (meth)acrylate/(meth)acrylic acid/if desired, other addition-polymerizable vinyl monomer] copolymers and [allyl (meth)acrylate/(meth)acrylic acid/if desired, other addition-polymerizable vinyl monomer] copolymers. In addition, polyvinylpyrrolidone, polyethylene oxide and the like are useful as the water-soluble organic high-molecular polymer. Also, an alcohol-soluble polyamide, a polyether of 2,2-bis-(4-hydroxyphenyl)-propane with epichlorohydrin, and the like are useful for increasing the strength of cured film. Furthermore, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful for usage of the present invention.

The strength of the cured film can be increased by introducing a radical reactive group into the side chain of the organic high-molecular polymer. Examples of the functional group capable of causing an addition polymerization reaction include an ethylenically unsaturated bond group, an amino group and an epoxy group; examples of the functional group capable of becoming a radical upon light irradiation include a mercapto group, a thiol group, a halogen atom, a triazine structure and an onium salt structure; and examples of the polar group include a carboxyl group and an imide group. As the functional group capable of causing an addition polymerization reaction, ethylenically unsaturated bond groups such as acryl group, methacryl group, allyl group and styryl group are preferred, but a functional group selected from an amino group, a hydroxy group, a phosphonic acid group, a phosphoric acid group, a carbamoyl group, an isocyanate group, a ureido group, a ureylene group, a sulfonic acid group and an ammonio group is also useful.

The binder preferably has an appropriate molecular weight and an appropriate acid value so as to maintain the developability of the photosensitive layer, and high-molecular polymers having a weigh average molecular weight of 5,000 to 300,000 and an acid value of 20 to 200 are effectively used. The binder can be mixed in an arbitrary amount in the entire composition for the photosensitive layer.

Particularly, when the binder is contained in an amount of 90 weight% or less in the photopolymerizable photosensitive layer, this provides preferred effects in view of strength and the like of the image formed. The amount of the binder contained is preferably from 10 to 90 weight%, more preferably from 30 to 80 weight%.

The amount of the ethylenically unsaturated bond-containing compound is, in terms of the weight ratio to the binder, preferably 1.5 times or more, more preferably from 1.5 to 10 times, still more preferably from 1.5 to 8 times, yet still more preferably from 1.6 to 5 times.

(c) Photopolymerization Initiator

The photopolymerization initiator contained in the photopolymerizable photosensitive layer may be appropriately selected according to the wavelength of light source used from various photo-initiators known in patents and publications, and combination systems (photo-initiation systems) of two or more photo-initiators. Specific examples are set forth below, but the present invention is not limited thereto.

In the case of using visible light at 400 nm or more, Ar laser, second harmonic wave of semiconductor laser, or SHG-YAG laser as the light source, various photo-initiation systems are also proposed and examples thereof include a certain kind of photoreducing dyes described in U.S. Patent 2,850,445, such as Rose Bengale, eosin and erythrosine, and a combination system of a dye with an initiator, such as a composite initiation system of dye and amine (see, JP-B-44-20189), a combination system of hexaarylbiimidazole, radical generator and dye (see, JP-B-45-37377), a system of hexaarylbiimidazole and p-dialkylaminobenzylidene ketone (see, JP-B-47-2528 and JP-A-54-155292), a system of cyclic cis-$\alpha$-dicarbonyl compound and dye (see, JP-A-48-84183), a system of cyclic triazine and merocyanine dye (see, JP-A-54-151024), a system of 3-ketocoumarin and activator (see, JP-A-52-112681 and JP-A-58-15503), a system of biimidazole, styrene derivative and thiol (see, JP-A-59-140203), a system of organic peroxide and dye (see, JP-A-59-1504, JP-A-59-140203, JP-A-59-189340, JP-A-62-174203, JP-B-62-1641 and U.S. Patent 4,766,055), a system of dye and active halogen compound (see, JP-A-63-258903 and JP-A-2-63054), a system of dye and borate compound (see, JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of dye having a rhodanine ring and radical generator (see, JP-A-2-179643 and JP-A-2-244050), a system of titanocene and 3-ketocoumarin dye (see, JP-A-63-221110), a combination system of titanocene, xanthene dye and addition-polymerizable ethylenically unsaturated compound containing an amino group or a urethane group (see, JP-A-4-221958 and JP-A-4-219756), a system of titanocene and specific merocyanine dye (see, JP-A-6-295061) and a system of titanocene and dye having

a benzopyran ring (see, JP-A-8-334897).

In recent years, a laser (violet laser) at a wavelength of 400 to 410 nm has been developed and also, a photo-initiation system respondent thereto and exhibiting high sensitivity to the wavelength of 450 nm or less has been developed. Such a photo-initiation system can also be used.

Examples thereof include a cationic dye/borate system (see, JP-A-11-84647), a merocyanine dye/titanocene system (see, JP-A-2000-147763) and a carbazole-type dye/titanocene system (see, Japanese Patent Application No. 11-221480).

In the present invention, systems using a titanocene compound are preferred, because these are excellent in view of sensitivity.

As the titanocene compound, various compounds can be used, but a titanocene compound may be appropriately selected from the compounds described in JP-A-59-152396 and JP-A-61-151197. Specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,6-difluorophen-1-yl and dicyclopentadienyl-Ti-bis-2,6-difluoro-3-(pyr-1-yl)phen-1-yl.

These photo-initiators are known to be more enhanced in the photo-initiation ability by adding thereto, as needed, a hydrogen-donating compound such as thiol compound (e.g., 2-mercaptobenzothiazole, 2-mercaptobenzimidazole, 2-mercaptobenzoxazole), N-phenylglycine and amine compound (e.g., N,N-dialkylamino aromatic alkyl ester).

The photopolymerization initiator (system) is generally used in an amount of 0.05 to 100 parts by weight, preferably from 0.1 to 70 parts by weight, more preferably from 0.2 to 50 parts by weight, per 100 parts by weight of the ethylenically unsaturated bond-containing compound.

In the photopolymerizable composition for forming the photopolymerizable photosensitive layer of the present invention, various compounds such as thermal polymerization initiator, coloring agent and plasticizer may be used in combination with those ethylenically unsaturated group-containing compound, alkali developer-soluble or swellable binder and photopolymerization initiator.

In the present invention, in order to prevent the polymerizable ethylenically unsaturated bond-containing compound from undergoing unnecessary thermal polymerization during the production or storage of the photopolymerizable composition for use in the photopolymerizable layer, a small amount of a thermal polymerization inhibitor is preferably added in addition to the above-described basic components. Suitable examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerous salt and N-nitrosophenylhydroxylamine aluminum salt. The amount of the thermal polymerization inhibitor added is preferably from about 0.01 to about 5 weight% based on the weight of the entire solid content of the composition. If desired, in order to prevent polymerization inhibition by oxygen, a higher fatty acid derivative or the like, such as behenic acid and behenic acid amide, may be added and localized on the photopolymerizable photosensitive layer surface during drying after the coating. The amount of the higher fatty acid derivative or the like added is preferably from about 0.5 to about 10 weight% based on the entire solid content of the composition.

A coloring agent may be further added for the purpose of coloring the photopolymerizable photosensitive layer. Examples of the coloring agent include pigments such as phthalocyanine-base pigment (e.g., C.I. Pigment Blue 15:3, 15:4, 15:6), azo-base pigment, carbon black and titanium oxide, and dyes such as Ethyl Violet, Crystal Violet, azo dye, anthraquinone-base dye and cyanine-base dye. The amount of the dye or pigment added is preferably from about 0.5 to about 20 weight% based on the entire composition. In addition, additives such as inorganic filler and plasticizer (e.g., dioctyl phthalate, dimethyl phthalate, tricresyl phosphate) may be added for improving physical properties of the cured film. The amount of such an additive added is preferably 10 weight% or less of the entire solid content of the composition (entire composition).

In coating the photopolymerizable composition, the composition is used after dissolving it in an organic solvent of various types. Examples of the solvent used here include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate and ethyl lactate. These solvents can be used individually or as a mixture. The concentration of solid contents in the coating solution is generally from 1 to 50 weight%.

In the photopolymerizable composition, a surfactant can be added so as to enhance the coated surface quality. The coverage of the surfactant is, in terms of the weight after drying, preferably from about 0.1 to about 10 g/m$^2$, more preferably from 0.3 to 5 g/m$^2$, still more preferably from 0.5 to 3 g/m$^2$.

[Support]

In the photosensitive lithographic printing plate of the present invention, the above-described photopolymerizable photosensitive layer is preferably provided on a support having a hydrophilic surface. As the hydrophilic support, conventionally known hydrophilic supports used for photosensitive lithographic printing plates can be used without limitation. The support used is preferably a plate-like material having dimensional stability. Examples thereof include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal. If desired, the surface of the support may be subjected to an appropriate known physical or chemical treatment for the purpose of imparting hydrophilic property or improving the strength.

Among these supports, preferred are paper, polyester film and aluminum plate, more preferred is aluminum plate, because the aluminum plate has good dimensional stability, is relatively inexpensive and can provide a surface having excellent hydrophilic property or strength, if desired, by a surface treatment. A composite sheet described in JP-B-48-18327 comprising a polyethylene terephthalate film having bonded thereon an aluminum sheet is also preferred.

The aluminum plate is a dimensionally stable metal sheet mainly comprising aluminum and this is selected from a pure aluminum plate, an alloy plate mainly comprising aluminum and containing trace hetero-elements, and a paper or plastic film having laminated or vapor-deposited thereon aluminum (or aluminum alloy).

In the following, these substrates comprising aluminum or an aluminum alloy are collectively called an aluminum substrate. Examples of the hetero-element contained in the aluminum alloy include silicon, iron, manganese, copper, magnesium, chromium, zinc, bismuth, nickel and titanium. The hetero-element content in the alloy is 10 weight% or less. A pure aluminum plate is preferred in the present invention, but a perfectly pure aluminum is difficult to produce in view of the refining technique and therefore, trace hetero-elements may be contained.

The aluminum plate for use in the present invention is not specified in its composition and conventionally known and employed materials such as JIS A 1050, JIS A 1100, JIS A 3103 and JIS A 3005 can be appropriately used. The thickness of the aluminum substrate for use in the present invention is approximately from about 0.1 to about 0.6 mm, preferably from 0.15 to 0.4 mm, more preferably from 0.2 to 0.3 mm. This thickness can be appropriately changed according to the size of press, the size of printing plate or demand of user. The aluminum plate may be appropriately subjected, if desired, to a surface treatment which is described later. Of course, the aluminum plate may not be subjected to a surface treatment.

(Surface Roughening Treatment)

The aluminum substrate is usually subjected to a surface roughening treatment.

Examples of the surface roughening method include mechanical surface roughening, chemical etching and electrolytic graining disclosed in JP-A-56-28893. Also, the surface roughening may be performed by an electrochemical surface roughening method of electrochemically roughening the surface in a hydrochloric acid or nitric acid electrolytic solution, or by a mechanical surface roughening method such as wire brush graining method of scrabbling the aluminum surface with a metal wire, ball graining method of graining the aluminum surface with an abrasive ball and an abrasive, and brush graining method of roughening the surface with a nylon brush and an abrasive. These surface-roughening methods may be used individually or in combination.

Among these surface roughening methods, useful is an electrochemical method of chemically roughening the surface in a hydrochloric acid or nitric acid electrolytic solution. In this case, the electric amount at anode time is suitably from 50 to 400 C/dm$^2$. More specifically, a.c. and/or d.c. electrolysis is preferably performed in an electrolytic solution containing from 0.1 to 50% of hydrochloric acid or nitric acid under the conditions such that the temperature is from 20 to 80°C, the treatment time is from 1 second to 30 minutes and the current density is from 100 to 400 C/dm$^2$.

The thus surface-roughened aluminum substrate may be chemically etched with an acid or an alkali. Examples of the etching agent which is suitably used include sodium hydroxide, sodium carbonate, sodium aluminate, sodium metasilicate, sodium phosphate, potassium hydroxide and lithium hydroxide. The concentration and temperature are preferably from 1 to 50% and from 20 to 100°C, respectively. After etching, pickling is performed for removing smut remaining on the surface. Examples of the acid used for pickling include nitric acid, sulfuric acid, phosphoric acid, chromic acid, hydrofluoric acid and borofluoric acid. In particular, the desmutting method after electrochemical surface-roughening includes a method of bringing the etched surface into contact with from 15 to 65 weight% of sulfuric acid at a temperature of 50 to 90°C described in JP-A-53-12739, and an alkali etching method described in JP-B-48-28123.

The method and conditions are not particularly limited as long as the centerline average roughness Ra on the treated surface is from 0.2 to 0.5 μm after the treatment.

(Anodization Treatment)

The thus surface-roughened aluminum substrate is then subjected to anodization to form an oxide film.

In the anodization, aqueous solutions of sulfuric acid, phosphoric acid, oxalic acid and boric acid/sodium borate are used individually or in combination of two or more thereof as the main component of the electrolysis bath. At this time, components usually contained in Al alloy plate, electrode, tap water, groundwater and the like may be of course contained in the electrolytic solution. Furthermore, second and third components may be added. Examples of the second and third components used here include cations such as metal ion (e.g., Na, K, Mg, Li, Ca, Ti, Al, V, Cr, Mn, Fe, Co, Ni, Cu, Zn) and ammonium ion, and anions such as nitrate ion, carbonate ion, chloride ion, phosphate ion, fluoride ion, sulfite ion, titanate ion, silicate in and borate ion. As for the concentration thereof, such a component may be contained in an amount of approximately from 0 to 10,000 ppm. The conditions for anodization are not particularly limited, but this treatment is preferably performed by d.c. or a.c. electrolysis in an electrolytic solution of 30 to 500 g/liter at a solution temperature of 10 to 70°C and a current density of 0.1 to 40 A/$m^2$. The thickness of the anodic oxide film formed is from 0.5 to 1.5 μm, preferably from 0.5 to 1.0 μm.

The treatment conditions must be selected such that in the support produced by this treatment, the pore size of micropores present in the anodic oxide film is in the range from 5 to 10 nm and the pore density is in the range from $8\times10^{15}$ to $2\times10^{16}$ pores/$m^2$.

A support which is, after these treatments, undercoated with a water-soluble resin such as polyvinyl phosphonate, a polymer or copolymer having a sulfonate group on the side chain, a polyacrylic acid, a water-soluble metal salt (e.g., zinc borate), a yellow dye or an amine salt is also suitably used. In addition, a sol-gel treated substrate obtained by covalent bonding a functional group capable of causing an addition reaction under the action of a radical, disclosed in Japanese Patent Application No. 5-304358, is also suitably used.

Other suitable examples include a support obtained by providing a water-resistant hydrophilic layer as a surface layer on an arbitrary support. Examples of the surface layer include a layer comprising an inorganic pigment and a binder described in U.S. Patent 3,055,295 and JP-A-56-13168, a hydrophilic swelling layer described in JP-A-9-80744, and a sol-gel film comprising titanium oxide, polyvinyl alcohol and a silicic acid described in JP-T-8-507727 (the term "JP-T" as used herein means a "published Japanese translation of PCT patent application"). These hydrophilization treatments are applied not only to render the support surface hydrophilic but also to prevent a harmful reaction of the photopolymerizable composition provided on the support and at the same time, improve the adhesive property and the like of the photosensitive layer.

[Interlayer]

In the photosensitive lithographic printing plate of the present invention, an interlayer may be provided for the purpose of improving soiling property or adhesive property between the photosensitive layer and the substrate. Specific examples of the interlayer include those described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, and Japanese Patent Application Nos. 8-225335, 8-270098, 9-195863, 9-195864, 9-89646, 9-106068, 9-183834, 9-264311, 9-127232, 9-245419, 10-127602, 10-170202, 11-36377, 11-165861, 11-284091 and 2000-14697.

[Protective Layer]

In the photosensitive lithographic printing plate of the present invention, a protective layer is preferably further provided on the photopolymerizable composition layer, because exposure is usually performed in air. The protective layer prevents the photosensitive layer from invasion of a low molecular compound which inhibits the image formation reaction generated by exposure in the photosensitive layer, such as oxygen present in air and basic substance, and enables exposure in air. In this meaning, the property required of the protective layer is low permeability to low molecular compounds such as oxygen. Furthermore, the protective layer preferably has a property of not substantially inhibiting the transmission of light used for exposure, exhibiting excellent adhesive property to the photosensitive layer and being easily removable in the development step after exposure. Techniques regarding such a protective layer have been heretofore proposed and these are described in detail in U.S. Patent 3,458,311 and JP-A-55-49729.

The material which can be used for the protective layer is preferably, for example, a water-soluble polymer compound having relatively excellent crystallinity, and specific known examples thereof include water-soluble polymers such as polyvinyl alcohol, polyvinylpyrrolidone, acidic celluloses, gelatin, gum arabic and polyacrylic acid. Among these, a polyvinyl alcohol is preferably used as the main component, because most excellent results are provided on the basic properties such as oxygen blocking ability and removal by development. The polyvinyl alcohol for use in the protective layer may be partially substituted by an ester, an ether or an acetal as long as it contains an unsubstituted vinyl alcohol unit for ensuring necessary oxygen blocking ability and water solubility. Also, other copolymerization component may be present in a part of the polyvinyl alcohol. Examples of the polyvinyl alcohol include those having a hydrolysis degree of 71 to 100% and a molecular weight of 300 to 2,400.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (selection of PVA and use of additives), coated amount and the like of the protective layer are selected by taking account of oxygen blocking ability, removal by development, fogging, adhesion and scratch resistance. In general, the oxygen blocking ability is higher as the hydrolysis ratio of PVA used is higher (as the content of unsubstituted vinyl alcohol unit in the protective layer is higher) and as the layer thickness is larger, and this is advantageous in view of sensitivity. However, if the oxygen blocking ability is increased to an extreme extent, a problem arises, for example, an unnecessary polymerization reaction takes place during production or stock storage, or undesirable fogging or thickening of image line is caused at the image exposure. The adhesion to the image area and scratch resistance are also very important factors in view of handling of the plate. That is, when a hydrophilic layer comprising a water-soluble polymer is laminated on a lipophilic polymerization layer, layer separation readily occurs due to poor adhesive strength and the separated portion brings about problems such as curing failure due to polymerization inhibition by oxygen.

For improving the adhesion between these two layers, various techniques have been proposed. For example, U.S. Patents 292501 and 44563 describe a technique where from 5 to 80 weight% of an acrylic emulsion or water-insoluble vinylpyrrolidone-vinyl acetate copolymer is mixed in a hydrophilic polymer mainly comprising polyvinyl alcohol and the polymer is laminated on a polymerization layer, whereby sufficiently high adhesive property can be obtained. These known techniques all can be applied to the protective layer of the present invention. The coating method of this protective layer is described in detail, for example, in U.S. Patent 3,458,311 and JP-A-55-49729.

The protective layer may also be imparted with other functions. For example, when a coloring agent (e.g., water-soluble dye) having excellent transmitting property for light at 350 to 450 nm used for exposure and capability of efficiently absorbing light of 500 nm or more is added, the safe light aptitude can be more enhanced without causing decrease in the sensitivity.

The coverage of the protective layer is, in terms of the weight after drying, generally from about 0.1 to about 15 g/m$^2$, preferably from 1.0 to about 5.0 g/m$^2$.

[Plate-Making Method]

In the photosensitive lithographic printing plate of the present invention, an image is usually obtained by performing image exposure and then removing the unexposed area of the photosensitive layer with a developer.

In the plate-making process of the photosensitive lithographic printing plate of the present invention, if desired, the entire surface may be heated before or during exposure or between exposure and development. By this heating, the image forming reaction in the photosensitive layer is accelerated and this provides advantageous effects such as enhancement of sensitivity or press life and stabilization of sensitivity. Also, after-heating or exposure of the entire surface of the image after development is effective for the purpose of improving the image strength and press life. Usually, the heating before development is preferably performed under a mild condition of 150°C or less. If the heating temperature is too high, problems such as fogging of even the non-image area arise. For the heating after development, a very strong condition is employed. This heating is usually performed at 200 to 500°C. If the heating temperature is low, a satisfactory image-strengthening effect cannot be obtained, whereas if it is too high, problems such as deterioration of support or thermal decomposition of image area are caused.

In exposing the lithographic printing plate for scanning exposure of the present invention, known methods can be used without limitation. The wavelength of the light source is preferably from 350 to 450 nm and, specifically, an InGaN-base semiconductor laser is suitable. The exposure mechanism may be any of an internal drum system, an external drum system, a flat bed system and the like. In the present invention, the photosensitive layer components can be made soluble in neutral water or weakly alkali solution by using components having high water solubility and in the case of a lithographic printing plate having such a constitution, a system of loading the plate on a press and performing exposure-development on the press can also be employed.

Examples of the exposure light which can be used for the photopolymerizable composition of the present

invention include an ultra-high pressure, high-pressure, medium-pressure or low-pressure mercury lamp, a chemical lamp, a carbon arc lamp, a xenon lamp, a metal halide lamp, various visible or ultraviolet laser lamps, a fluorescent lamp, a tungsten lamp and sunlight. As the available laser light source of 350 to 450 nm, the followings can be used:

as a gas laser, an Ar ion laser (364 nm, 351 nm, 10 mW to 1 W), a Kr ion laser (356 nm, 351 nm, 10 mW to 1 W) and a He-Cd laser (441 nm, 325 nm, 1 mW to 100 mW); as a solid laser, a combination of Nd:YAG($YVO_4$) and SHG crystal×2 times (355 nm, 5 mW to 1 W), and a combination of Cr:LiSAF and SHG crystal (430 nm, 10 mW); as a semiconductor laser system, a $KNbO_3$ ring resonator (430 nm, 30 mW), a combination of a wave guide-type wavelength conversion element and an AlGaAs or InGaAs semiconductor (380 to 450 nm, 5 to 100 mW), a combination of a wave guide-type wavelength conversion element and an AlGaInP or AlGaAs semiconductor (300 to 350 nm, 5 to 100 mW), and AlGaInN (350 to 450 nm, 5 to 30 mW); and as a pulse laser, a $N_2$ laser (337 nm, pulse: 0.1 to 10 mJ) and XeF (351 nm, pulse: 10 to 250 mJ). Among these, an AlGaInN semiconductor laser (commercially available InGaN-base semiconductor laser, 400 to 410 nm, 5 to 30 mW) is preferred in view of wavelength properties and cost.

The apparatus employing the scanning exposure system includes, as the exposure mechanism, an internal drum system, an external drum system and a flat bed system and out of the above-described light sources, those capable of continuous oscillation can be preferably used as the light source. In practice, the following exposure devices are particularly preferred in view of relationship between the sensitivity of photosensitive material and the plate-making time:

a single-beam to triple-beam exposure device employing an internal drum system and using one or more gas or solid laser light source to give a semiconductor laser having a total output of 20 mW or more; a multi-beam (from 1 to 10 beams) exposure device employing a flat bed system and using one or more semiconductor, gas or solid laser to give a total output of 20 mW or more; a multi-beam (from 1 to 9 beams) exposure device employing an exterior drum system and using one or more semiconductor, gas or solid laser to give a total output of 20 mW or more; and a multi-beam (10 or more beams) exposure device employing an exterior drum system and using one or more semiconductor or solid laser to give a total output of 20 mW.

In the above-described laser direct drawing-type lithographic printing plate, the following equation (eq. 1) is generally established among sensitivity X ($J/cm^2$) of photosensitive material, exposure area S ($cm^2$) of photosensitive material, power q (W) of one laser light source, number n of lasers and entire exposure time t (s):

$$X \cdot S = n \cdot q \cdot t \qquad \text{(eq. 1)}$$

i) In the case of internal drum (single beam) system, the following equation (eq. 2) is generally established among laser rotation number f (radian/s), sub-scanning length Lx (cm) of photosensitive material, resolution Z (dot/cm) and entire exposure time t (s):

$$f \cdot Z \cdot t = Lx \qquad \text{(eq. 2)}$$

ii) In the case of external drum (multi-beam) system, the following equation (eq. 3) is generally established among drum rotation number F (radian/s), sub-scanning length Lx (cm) of photosensitive material, resolution Z (dot/cm), entire exposure time t (s) and number (n) of beams:

$$F \cdot Z \cdot n \cdot t = Lx \qquad \text{(eq. 3)}$$

iii) In the case of flat bed (multi-beam) system, the following equation (eq. 4) is generally established among rotation number H (radian/s) of polygon mirror, sub-scanning length Lx (cm) of photosensitive material, resolution Z (dot/cm), entire exposure time t (s) and number of beams (n):

$$H \cdot Z \cdot n \cdot t = Lx \qquad \text{(eq. 4)}$$

When resolution (2,560 dpi) required of a practical printing plate, plate size (A1/B1, sub-scanning length: 42

inch), exposure condition of about 20 sheets/1 hour and photosensitive properties (photosensitive wavelength, sensitivity: about 0.1 $mJ/cm^2$) of the photosensitive composition of the present invention are substituted for the equations above, it can be understood that a combination of the photosensitive material of the present invention with a multi-beam exposure system using a laser having a total output of 20 mW or more is preferred. However, in the case of using a laser having a necessary and sufficiently large output (30 mW or more), combination with a semiconductor laser single-beam exposure device employing an internal drum system is most preferred in view of operation, cost and the like.

Also, for the purpose of elevating the curing ratio of the photopolymerizable photosensitive layer, a heating process at a temperature of 50 to 150°C for a time period of 1 second to 5 minutes is preferably provided between conventionally known processes, that is, image exposure with actinic rays and development, because the curability of non-image area is enhanced and the press life is more elongated.

The developed photosensitive lithographic printing plate is after-treated with washing water, rinsing solution containing surfactant and the like, or a desensitizing solution containing gum arabic, starch derivative or the like as described in JP-A-54-8002, JP-A-55-115045 and JP-A-59-58431. For the after-treatment of the photosensitive lithographic printing plate of the present invention, these treatments can be used in various combinations.

The lithographic printing plate obtained through such a treatment is mounted on an offset printing machine and used for the printing of a large number of sheets.

The above-described photosensitive lithographic printing plate can be developed with a conventionally known developer to form an image. Examples of the conventionally known developer include developers described in JP-B-57-7427. The developer is suitably an aqueous solution of an inorganic alkali agent such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate and aqueous ammonia, or an organic alkali agent such as monoethanolamine and diethanolamine. The concentration of the alkali solute in the developer is generally from 0.1 to 10 weight%, preferably from 0.5 to 5 weight%.

If desired, the alkali developer may contain a small amount of a surfactant or an organic solvent such as benzyl alcohol, 2-phenoxyethanol and 2-butoxyethanol. Examples thereof include those described in U.S. Patents 3,375,171 and 3,615,480. Also, developers described in JP-A-50-26601, JP-A-58-54341, JP-B-56-39464 and JP-B-56-42860 may be used.

In view of serious missing of dot or missing of fine line or the like in the solid part, as described above, the developer used for the plate making of the photosensitive lithographic printing plate of the present invention is preferably an alkali developer having a pH of 10.5 to 13.5 (more preferably from 1.0 to 12.5) and containing a nonionic surfactant having a polyoxyalkylene ether group.

By containing a nonionic surfactant having a polyoxyalkylene ether group, dissolution of the photosensitive layer in the unexposed area can be accelerated and penetration of the developer into the exposed area can be decreased. The surfactant having a polyoxyalkylene ether group is preferably a compound having a structure represented by the following formula (B):

$$R^3\text{-O-}(R^4\text{-O})_qH \qquad \text{(B)}$$

wherein $R^3$ represents an alkyl group having from 3 to 15 carbon atoms, which may have a substituent, an aromatic hydrocarbon group having from 6 to 15 carbon atoms, which may have a substituent, or a hetero-aromatic ring group having from 4 to 15 carbon atoms, which may have a substituent (examples of the substituent include an alkyl group having from 1 to 20 carbon atoms, a halogen atom such as Br, Cl and I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms), $R^4$ represents an alkylene group having from 1 to 100 carbon atoms, which may have a substituent (examples of the substituent include an alkyl group having from 1 to 20 carbon atoms and an aromatic hydrocarbon group having from 6 to 15 carbon atoms), and q represents an integer of 1 to 100.

In the definitions of formula (B), specific examples of the "aromatic hydrocarbon group" include a phenyl group, a tolyl group, a naphthyl group, an anthryl group, a biphenyl group and a phenanthryl group, and specific examples of the "hetero-aromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

In formula (I), the moiety of $(R^4\text{-O})_q$ may consist of two or three kinds of groups within the above-described range. Specific examples thereof include combinations of ethyleneoxy group and propyleneoxy group, ethyleneoxy group and isopropyloxy group, ethyleneoxy group and butyleneoxy group, and ethyleneoxy group and isobutylene

group, where these groups are linked in a random or block state. In the present invention, the surfactants having a polyoxyalkylene ether group are used individually or as a composite system and it is effective to add the surfactant in an amount of 1 to 30 weight%, preferably from 2 to 20 weight%, in the developer. If the amount added is too small, the developability decreases, whereas if too large, the damage by development becomes strong and the press life of the printing plate decreases.

Examples of the nonionic surfactant having a polyoxyalkylene ether group, represented by formula (B), include polyoxyethylene alkyl ethers such as polyoxyethylene lauryl ether, polyoxyethylene cetyl ether and polyoxyethylene stearyl ether, polyoxyethylene aryl ethers such as polyoxyethylene phenyl ether and polyoxyethylene naphthyl ether, and polyoxyethylene alkylaryl ethers such as polyoxyethylene methylphenyl ether, polyoxyethylene octylphenyl ether and polyoxyethylene nonylphenyl ether.

Furthermore, the following other surfactants may be also added. Examples of the other surfactants which can be used include nonionic surfactants such as polyoxyethylene alkyl esters (e.g., polyoxyethylene stearate), sorbitan alkyl esters (e.g., sorbitan monolaurate, sorbitan monostearate, sorbitan distearate, sorbitan monooleate, sorbitan sesquioleate, sorbitan trioleate) and monoglyceride alkyl esters (e.g., glycerol monostearate, glycerol monooleate); anionic surfactants such as alkyl benzene sulfonates (e.g., sodium dodecylbenzenesulfonate), alkyl naphthalene sulfonates (e.g., sodium butylnaphthalenesulfonate, sodium pentylnaphthalenesulfonate, sodium hexylnaphthalenesulfonate, sodium octylnaphthalenesulfonate), alkyl sulfates (e.g., sodium laurylsulfate), alkyl sulfonates (e.g., sodium dodecyl sulfonate) and sulfosuccinic ester salts (e.g., sodium dilaurylsulfosuccinate); and amphoteric surfactants such as alkyl betaines (e.g., lauryl betaine, stearyl betaine) and aminoacids. Among these, particularly preferred are anionic surfactants such as alkylnaphthalenesulfonates.

These surfactants can be used individually or in combination. The content of the surfactant in the developer is preferably from 0.1 to 20 weight% in terms of effective components.

The alkali developer usually contains an inorganic alkali salt. An inorganic alkali salt can be appropriately selected, but examples thereof include inorganic alkali agents such as sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. These alkali agents may be used individually or in combination of two or more thereof.

In the case of using a silicate, the developability can be easily adjusted by controlling the mixing ratio between silicon oxide $SiO_2$ and alkali oxide $M_2O$ (M represents an alkali metal or an ammonium group), which are components of the silicate, and the concentration. In the alkali aqueous solution, the mixing ratio ($SiO_2/M_2O$ by mol) of silicon oxide $SiO_2$ and alkali oxide $M_2O$ is preferably from 0.5 to 3.0, more preferably from 1.0 to 2.0. If $SiO_2/M_2O$ is less than 0.5, the concentration is preferably from 1 to 10 weight%, more preferably from 3 to 8 weight%, and most preferably from 4 to 7 weight%, based on the weight of the alkali aqueous solution. If this concentration is less than 1 weight%, the developability and processing ability sometimes decrease, whereas if it exceeds 10 weight%, precipitate or crystal is readily produced and also, gelling readily occurs at the neutralization of waste solution to cause a problem in the treatment of waste solution.

For the purpose of delicately adjusting the alkali concentration and assisting the dissolution of photosensitive layer, an organic alkali agent may be supplementarily used in combination. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. These alkali agents are used individually or in combination of two or more thereof.

The electric conductivity of the developer for use in the present invention is preferably from 3 to 30 mS/cm. If the electric conductivity is less than this range, the photosensitive composition on the aluminum plate support surface can hardly dissolve out and the printing may be accompanied with staining, whereas if it exceeds this range, the photosensitive layer dissolves out at an extremely low rate due to high salt concentration and film remaining may be caused on the unexposed area. The electric conductivity is more preferably from 5 to 20 mS/cm.

## EXAMPLES

The present invention is described in greater detail below by referring to Examples, but the present invention is not limited to these Examples.

[Examples 1 to 12 and Comparative Examples 1 to 4]

The surface of a 0.30 mm-thick aluminum plate formed of a material 1S was grained by using a No. 8 nylon

brush and a water suspension of 800-mesh pumice stone, and then thoroughly washed with water. This aluminum plate was etched by immersing it in 10% sodium hydroxide at 70°C for 60 seconds, washed with running water, neutralized and washed with 20% $HNO_3$ and then washed with water. This plate was subjected to an electrolytic surface roughening treatment in an aqueous 1% nitric acid solution by using an alternating current with a sinusoidal waveform at an anode time electricity of 300 coulomb/dm$^2$ under the condition of $V_A$=12.7 V. The surface roughness was measured and found to be 0.45 µm (Ra indication). Subsequently, the plate was desmutted at 55°C for 2 minutes by immersing it in an aqueous 30% $H_2SO_4$ solution, and then anodized in an aqueous 20% $H_2SO_4$ solution at 33°C for 50 seconds with a current density of 5 A/dm$^2$ by disposing a cathode on the grained surface, as a result, the thickness was 2.7 g/m$^2$.

On the thus-obtained support, the following liquid composition for undercoating as the surface treatment was coated to give an Si amount of about 0.001 g/m$^2$ and dried. This support was designated as Support 1.

<Liquid Composition for Undercoating>

The following components were mixed and stirred. After about 5 minutes, heat was generated. The reaction was allowed to proceed for 60 minutes and then the contents were transferred to a different vessel. Thereto, 30,000 parts by weight of methanol was further added to prepare a liquid composition for undercoating.

| | |
|---|---|
| Phosmer PE (acid phosphoxy·polyoxyethylene glycol mono-methacrylate produced by Uni-Chemical Co., Ltd.) | 20 parts by weight |
| Methanol | 130 parts by weight |
| Water | 20 parts by weight |
| p-Toluenesulfonic acid | 5 parts by weight |
| Tetraethoxysilane | 50 parts by weight |
| 3-Methacryloxypropyltriethoxysilane | 50 parts by weight |

[Production of Photosensitive Material]

On Support 1 prepared above, a photopolymerizable composition having the following composition was coated to give a dry coated weight shown in Table 1 and then dried at 90°C to form a photopolymerizable photosensitive layer.

Subsequently, on this photosensitive layer, a 3 weight% aqueous solution of polyvinyl alcohol (saponification degree: 98 mol%, polymerization degree: 500) was coated to give a dry coated weight of 2.5 g/m$^2$ and then dried at 100°C for 1 minute and 30 seconds to obtain a photosensitive lithographic printing plate (photosensitive material).

<Coating Solution for Photopolymerizable Photosensitive Layer>

| | |
|---|---|
| Ethylenically unsaturated bond-containing compound | shown in Table 1 |
| Binder | shown in Table 1 |
| Sensitizing dye | 0.15 g |

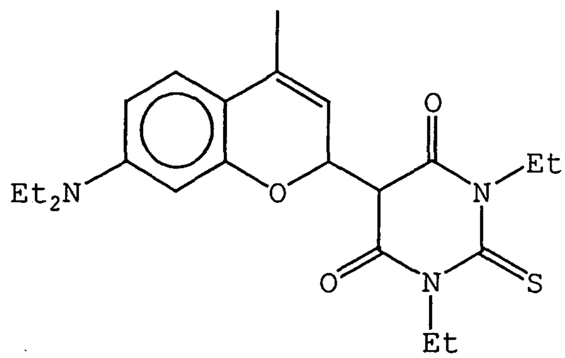

| | |
|---|---|
| Photo-initiator | 0.30 g |

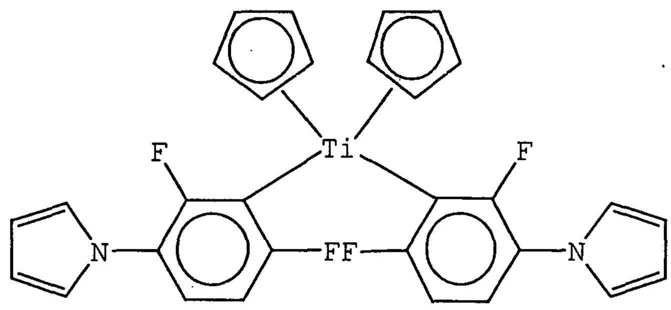

| | |
|---|---|
| Additive | 0.50 g |

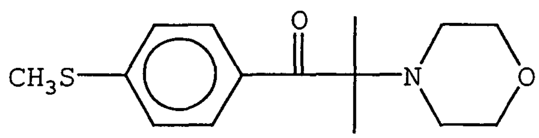

| | |
|---|---|
| Fluorine-containing surfactant (Megafac F177, produced by Dai-Nippon Ink & Chemicals, Inc.) | 0.03 g |
| Thermal polymerization inhibitor (N-nitrilohydroxylamine aluminum salt) | 0.01 g |
| Dispersion of ε-type copper phthalocyanine | 0.2 g |
| Methyl ethyl ketone | 30 g |
| Propylene glycol monomethyl ether | 30 g |

M1

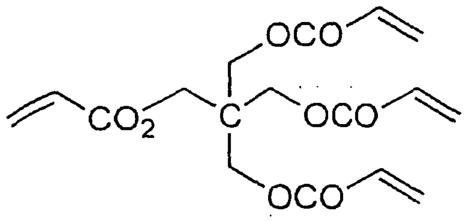

M2

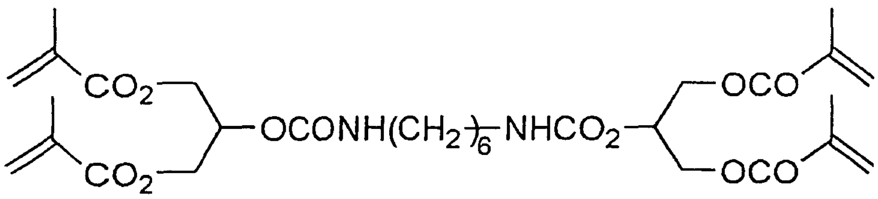

B1

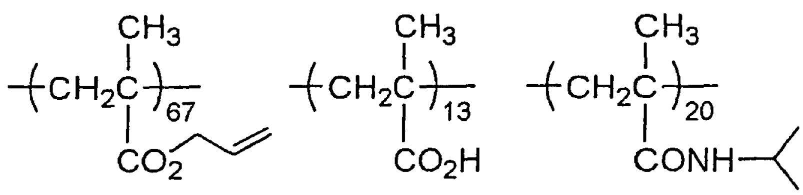

$\bar{M}w$ 150000

B2

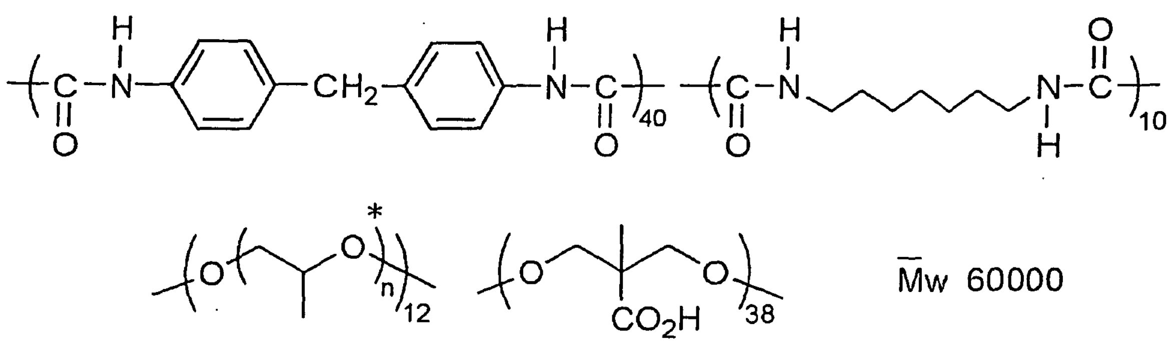

$\bar{M}w$ 60000

*: Polypropylene glycol moiety (average molecular weight: 1,000)

In order to examine the temperature dependency at exposure of the sensitivity of printing plate and the fluctuation of dot area, a test was performed by placing the plate material and an exposing machine having mounted thereon an FD·YAG laser (PLATE JET 4, manufactured by CSI) in a constant-temperature constant-humidity chamber. The exposing machine was set to give a light intensity of 0.2 mJ/$cm^2$ on the plate surface in an environment of 10°C and 50% RH, and 30°C and 50% RH. A solid image was exposed through a gray scale and a 50% mesh image of 175 lines was exposed by default. Thereafter, the plate material was subjected to a standard processing in an automatic developing machine (LP-850P2, manufactured by Fuji Photo Film Co., Ltd.) in which Developer 1 and a finishing gum liquid FP-2W (produced by Fuji Photo Film co., Ltd.) were charged. The preheating conditions were such that the ultimate temperature on plate surface was 100°C, the developer temperature was 30°C and the dipping time in developer was about 15 seconds.

Developer 1 was comprising the following composition and had a pH of 11.5 at 25°C and an electric conductivity of 5 mS/$cm^2$.

| (Composition of Developer 1) | |
|---|---|
| Potassium hydroxide | 0.15 g |
| Polyoxyethylene phenyl ether (n=15) | 5.0 g |
| CHELEST 400 (chelating agent, produced by Chelest Corporation) | 0.1 g |
| Water | 94.75 g |

The sensitivity was judged by the obtained gray scale step number. The gray scale step number of each sample is shown in Table 1. The gray scale is an optical wedge having an optical density difference of 1/√2 every each step and a scale higher by two steps indicates that the sensitivity is 2 times higher.

The dot area on the plate was determined by a commercially available measuring apparatus (CC-DOT, manufactured by Centurfax) and the results obtained are shown in Table 1.

Table 1

| | Ethylenically Unsaturated Bond-containing Compound (M) | Binder Polymer (B) | M/B | Softening Point of Photo-sensitive Layer | 10°C | | 30°C | | $S_{30}/S_{10}$ | Difference in Dot Area between 10°C and 30°C |
|---|---|---|---|---|---|---|---|---|---|---|
| | | | | | G/S | 50% Dot Area | G/S | 50% Dot Area | | |
| Example 1 | M1 12 g | B1 8 g | 1.5 | 45°C | 4.0 step | 54 | 5.0 step | 56 | 1.4 | 2 |
| Example 2 | M1 12.6 g | B1 7.4 g | 1.7 | 43°C | 4.5 step | 55 | 5.5 step | 57 | 1.4 | 2 |
| Example 3 | M1 13.3 g | B1 6.7 g | 2.0 | 37°C | 5.0 step | 56 | 5.5 step | 57 | 1.2 | 1 |
| Example 4 | M1 13.9 g | B1 6.1 g | 2.3 | 35°C | 5.2 step | 56 | 5.5 step | 57 | 1.2 | 1 |
| Example 5 | M1 14.3 g | B1 5.7 g | 2.5 | 19°C | 5.5 step | 57 | 5.7 step | 57 | 1.2 | 0 |
| Example 6 | M1 15 g | B1 5 g | 3.0 | 10°C | 5.7 step | 57 | 5.7 step | 57 | 1.0 | 0 |
| Example 7 | M2 12 g | B2 8 g | 1.5 | 44°C | 4.3 step | 50 | 5.3 step | 52 | 1.4 | 2 |
| Example 8 | M2 12.4 g | B2 7.4 g | 1.7 | 38°C | 4.5 step | 51 | 5.5 step | 53 | 1.4 | 2 |
| Example 9 | M2 13.3 g | B2 6.7 g | 2.0 | 32°C | 4.7 step | 52 | 5.5 step | 53 | 1.3 | 1 |
| Example 10 | M2 14.3 g | B2 5.7 g | 2.5 | 18°C | 5.5 step | 53 | 5.7 step | 54 | 1.2 | 1 |
| Example 11 | M2 15 g | B2 5 g | 3.0 | 8°C | 5.7 step | 53 | 5.7 step | 54 | 1.0 | 1 |
| Example 12 | M2 16 g | B2 4 g | 4.0 | 3°C | 6.0 step | 55 | 6.0 step | 55 | 1.0 | 0 |
| Comparative Example 1 | M1 10 g | B1 10 g | 1.0 | 55°C | 3.0 step | 48 | 5.0 step | 56 | 2.0 | 8 |
| Comparative Example 2 | M1 10.9 g | B1 9.1 g | 1.2 | 47°C | 3.5 step | 51 | 5.0 step | 56 | 1.8 | 4 |

| | | | | | | | | | | |
|---|---|---|---|---|---|---|---|---|---|---|
| Comparative Example 3 | M1 10 g | B2 10 g | 1.0 | 52°C | 2.5 step | 44 | 5.0 step | 53 | 2.8 | 7 |
| Comparative Example 4 | M2 10.9 g | B2 9.1 g | 1.2 | 46°C | 3.0 step | 47 | 5.0 step | 53 | 2.0 | 6 |

[Examples 13 and 14 and Comparative Examples 5 and 6]

The sensitivity and dot area were determined by utterly the same operation as in Example 9 and Comparative Example 3 except that Developer 1 used in the test of Example 9 and Comparative Example 3 was changed to Developer 2 or Developer 3 having the following composition. The results are shown in Table 2.

| Composition of Developer 2 (pH: 12.2, 20 mS/$cm^2$) | |
|---|---|
| 1K Potassium silicate | 2.5 g |
| Potassium hydroxide | 0.15 g |
| Polyoxyethylene naphthyl ether (n=10) | 5.0 g |
| CHELEST 400 | 0.1 g |
| Water | 92.25 g |

| Composition of Developer 3 (pH: 12.2, 25 mS/$cm^2$) | |
|---|---|
| 1K Potassium silicate | 1.5 g |
| Potassium hydroxide | 0.8 g |
| LIPOSIN LA (amphoteric surfactant) | 5.0 g |
| CHELEST 400 | 0.1 g |
| Water | 92.6 g |

Table 2

| | Plate Material | Developer | 10°C | | 30°C | | $S_{30}/S_{10}$ | Difference in Dot Area between 10°C and 30°C |
|---|---|---|---|---|---|---|---|---|
| | | | G/S | 50% Dot Area | G/S | 50% Dot Area | | |
| Example 13 | same as Example 9 | Developer 2 | 5.0 | 53 | 5.5 | 54 | 1.2 | 1 |
| Example 14 | same as Example 9 | Developer 3 | 5.0 | 53 | 5.5 | 56 | 1.2 | 3 |
| Comparative Example 5 | same as Comparative Example 3 | Developer 2 | 3.0 | 47 | 5.0 | 53 | 2.0 | 6 |
| Comparative Example 6 | same as Comparative Example 3 | Developer 3 | 3.0 | 47 | 5.0 | 54 | 2.0 | 7 |

[Example 15 and Comparative Example 7]

The sensitivity and dot area were determined by utterly the same operation as in Example 9 and Comparative Example 3 except that the sensitizing dye as a component of the photosensitive layer in Example 9 and Comparative Example 3 was changed to the compound shown below and the exposure was performed in a testing machine where a violet laser was mounted. The results obtained are shown in Table 3.

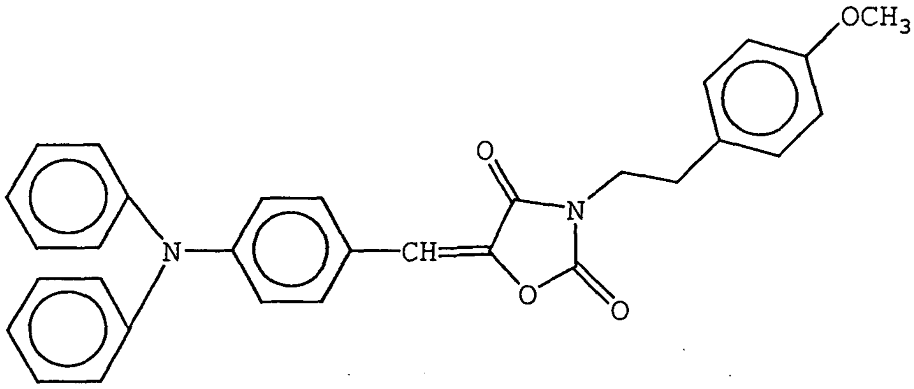

Table 3

| | 10°C | | 30°C | | | Difference in Dot Area between 10°C and 30°C |
|---|---|---|---|---|---|---|
| | G/S | 50% Dot Area | G/S | 50% Dot Area | $S_{30}/S_{10}$ | |
| Example 15 | 5.0 | 53 | 5.3 | 54 | 1.2 | 1 |
| Comparative Example 7 | 3.0 | 45 | 5.3 | 54 | 1.5 | 9 |

[Example 16]

The sensitivity and dot area at each temperature were measured by utterly the same operation as in Comparative Example 1 except that the binder polymer was changed to B3 shown below. The results obtained are shown in Table 4. B3:

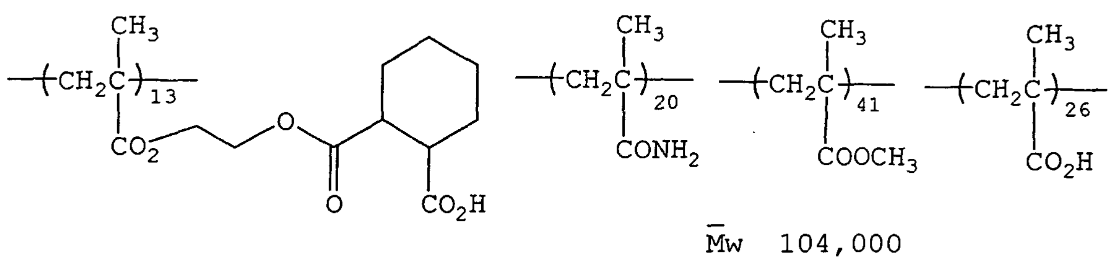

$\overline{M}w$ 104,000

Tg 44°C

Table 4

| | 10°C | | 30°C | | | Difference in Dot Area between 10°C and 30°C |
|---|---|---|---|---|---|---|
| | G/S | 50% Dot Area | G/S | 50% Dot Area | $S_{30}/S_{10}$ | |
| Example 16 | 4.5 | 52 | 5.0 | 53 | 1.2 | 1 |

As seen from these results, the photosensitive lithographic printing plate of the present invention is reduced in the fluctuation of dot area due to change of temperature at exposure and exhibits good performance.

This application is based on Japanese Patent application JP 2003-312623, filed September 4, 2003, the entire content of which is hereby incorporated by reference, the same as if set forth at length.

## Claims

1. A photosensitive lithographic printing plate comprising a support and a photopolymerizable photosensitive layer containing an addition-polymerizable compound having at least one ethylenically unsaturated double bond, an alkali developer-soluble or swellable binder and a photopolymerization initiator, wherein a ratio of a sensitivity upon exposure at 30°C to a sensitivity upon exposure at 10°C is from 1.0 to 1.7.

2. The photosensitive lithographic printing plate according to claim 1, wherein the photopolymerizable photosensitive layer has a softening point of 45°C or less.

3. The photosensitive lithographic printing plate according to claim 1, wherein a proportion of the addition-polymerizable compound in the photopolymerizable photosensitive layer is from 1.5 to 10 times by weight based on the alkali developer-soluble or swellable binder.

4. The photosensitive lithographic printing plate according to claim 1, wherein a proportion of the addition-polymerizable compound in the photopolymerizable photosensitive layer is from 1.5 to 8 times by weight based on the alkali developer-soluble or swellable binder.

5. The photosensitive lithographic printing plate according to claim 1, wherein a proportion of the addition-polymerizable compound in the photopolymerizable photosensitive layer is from 1.6 to 5 times by weight based on the alkali developer-soluble or swellable binder.

6. The photosensitive lithographic printing plate according to claim 1, which further comprises a protective layer, so that the support, the photopolymerizable photosensitive layer and protective layer are in this order.

7. The photosensitive lithographic printing plate according to claim 1, wherein the ratio of a sensitivity upon exposure at 30°C to a sensitivity upon exposure at 10°C is from 1.0 to 1.5.

8. The photosensitive lithographic printing plate according to claim 1, wherein the ratio of a sensitivity upon exposure at 30°C to a sensitivity upon exposure at 10°C is from 1.0 to 1.3.

9. The photosensitive lithographic printing plate according to claim 1, wherein the photopolymerizable photosensitive layer has a softening point of 35°C or less.

10. The photosensitive lithographic printing plate according to claim 1, wherein the binder is selected from the group consisting of acrylic binders, methacrylic binders and urethane binders.

11. The photosensitive lithographic printing plate according to claim 1, wherein the binder has a radical reactive group at a side chain thereof.

12. The photosensitive lithographic printing plate according to claim 1, wherein the addition-polymerizable compound is selected from the group consisting of polyfunctional acrylate monomers, polyfunctional methacrylate monomers and polyfunctional urethane monomers.

**13.** A method for processing a photosensitive lithographic printing plate, comprising: exposing the photosensitive lithographic printing plate according to claim 1; and developing the exposed plate with a developer having a pH of 10.5 to 13.5 and containing a compound having a polyoxyalkylene group.

**14.** The method according to claim 13, wherein the compound contained in the developer is a nonionic surfactant.

**15.** The method according to claim 14, wherein the compound contained in the developer is represented by the following formula (B):

$$R^3\text{-O-}(R^4\text{-O})_qH \qquad \text{(B)}$$

wherein $R^3$ represents an alkyl group having from 3 to 15 carbon atoms, which may have a substituent, an aromatic hydrocarbon group having from 6 to 15 carbon atoms, which may have a substituent, or a hetero-aromatic ring group having from 4 to 15 carbon atoms, which may have a substituent, $R^4$ represents an alkylene group having from 1 to 100 carbon atoms, which may have a substituent, and q represents an integer of 1 to 100.